# EUROPEAN PATENT SPECIFICATION

(11) **EP 3 557 642 B1**
(45) Date of publication and mention of the grant of the patent: **05.01.2022**
(21) Application number: 18798747.4
(22) Date of filing: 13.04.2018
(51) Int. Cl.: H01L 51/42, H01L 51/46

(54) **PHOTOACTIVE LAYER AND ORGANIC SOLAR CELL INCLUDING SAME**
PHOTOAKTIVE SCHICHT UND ORGANISCHE SOLARZELLE DAMIT
COUCHE PHOTOACTIVE ET CELLULE SOLAIRE ORGANIQUE LA COMPRENANT

(30) Priority: 11.05.2017 KR 20170058710; 12.04.2018 KR 20180042648
(43) Date of publication of application: 23.10.2019
(73) Proprietor: LG Chem, Ltd., Seoul 07336 (KR)
(72) Inventor: JANG, Songrim, Daejeon 34122 (KR); KIM, Kyungkon, Seoul 03760 (KR); KIM, Jinseck, Daejeon 34122 (KR); CHOI, Doowhan, Daejeon 34122 (KR); LIM, Bogyu, Daejeon 34122 (KR); CHO, Kyuwan, Seoul 03760 (KR)
(74) Representative: Hoffmann Eitle
(86) International application number: PCT/KR2018/004318
(87) International publication number: WO 2018/208021

(56) References cited:
- KR-A- 20150 015 413
- Lin Zhang ET AL: "Supporting Information: Poly(3-butylthiophene) Inducing Crystallization of Small Molecule Donor for Enhanced Photovoltaic Performance", JOURNAL OF PHYSICAL CHEMISTRY C, 24 September 2015 (2015-09-24), XP055659261, DOI: 10.1021/acs.jpcc.5b04850 Retrieved from the Internet: URL:https://pubs.acs.org/doi/suppl/10.1021 /acs.jpcc.5b04850/suppl_file/jp5b04850_si_ 001.pdf [retrieved on 2020-01-20]
- ZHANG, L. et al.: "Poly(3-butylthiophene) Inducing Crystallization of Small Molecule Donor for Enhanced Photovoltaic Performance", The Journal of Physical Chemistry, vol. 119, no. 41, 2015, pages 23310-23318, XP055561066,
- BI, P.-Q. et al.: "An Obvious Improvement in the Performance of Ternary Organic Solar Cells with 'Guest' Donor Present at the 'Host' Donor/Acceptor Interface", ACS Appl. Mater. Interfaces, vol. 8, no. 35, 2016, pages 23212-23221, XP055561069,
- ZHANG, J. et al.: "Conjugated Polymer-Small Molecule Alloy Leads to High Efficient Ternary Organic Solar Cells", J. Am. Chem. Soc., vol. 137, no. 25, 2015, pages 8176-8183, XP055561071,
- CHO, K. et al.: "Reducing Trap-Assisted Recombination in Small Organic Molecule- Based Photovoltaics by the Addition of a Conjugated Block Copolymer", Macromol. Rapid Commun., vol. 39, no. 5, 8 December 2017 (2017-12-08), page 1700630, XP055561074,

## Description

### [Technical Field]

The present specification relates to a photoactive layer and an organic solar cell including the same, as defined in the appended set of claims.

### [Background Art]

An organic solar cell is a device which may directly convert solar energy into electric energy by applying a photovoltaic effect. A solar cell may be divided into an inorganic solar cell and an organic solar cell, depending on the materials constituting a thin film. Typical solar cells are made through a p-n junction by doping crystalline silicon (Si), which is an inorganic semiconductor. Electrons and holes generated by absorbing light diffuse to p-n junction points and move to an electrode while being accelerated by the electric field. The power conversion efficiency in this process is defined as the ratio of electric power given to an external circuit and solar power entering the solar cell, and the efficiency have reached approximately 24% when measured under a currently standardized virtual solar irradiation condition. However, since inorganic solar cells in the related art have already shown the limitation in economic feasibility and material demands and supplies, an organic semiconductor solar cell, which is easily processed and inexpensive and has various functionalities, has come into the spotlight as a long-term alternative energy source.

For the solar cell, it is important to increase efficiency so as to output as much electric energy as possible from solar energy. In order to increase the efficiency of the solar cell, it is important to generate as many excitons as possible inside a semiconductor, but it is also important to pull the generated charges to the outside without loss. One of the reasons for the charge loss is the dissipation of generated electrons and holes due to recombination. Various methods have been proposed to deliver generated electrons and holes to an electrode without loss, but additional processes are required in most cases, and accordingly, manufacturing costs may be increased.

Zhang, L. et al (J. Phys. Chem. C 2015, 119, 41, 23310-23318) describe morphological control over the bulk heterojunction (BHJ) microstructure of 7'-(4,4-bis(2-ethylhexyl)-4H-silolo[3,2-b:4,5-b']dithiophene-2,6-diyl)bis(6-fluoro-4-(5'-hexyl-[2,2'-bithiophen]-5-yl)benzo[c] [1,2,5] (thiadiazole) (p-DTS(FBTTh₂)₂) and [6,6]phenyl-C₇₁-butyric acid methyl ester (PC₇₁BM) system by introducing a small amount of poly(3-butylthiophene) (P₃BT) into the active layer.

### [Detailed Description of the Invention]

### [Technical Problem]

The present specification provides a photoactive layer and an organic solar cell including the same.

### [Technical Solution]

An exemplary embodiment of the present specification provides a photoactive layer according to claim 1.

Another exemplary embodiment of the present specification provides an organic solar cell including: a first electrode; a second electrode provided to face the first electrode; and an organic material layer having one or more layers provided between the first electrode and the second electrode and including the photoactive layer according to claim 1.

### [Advantageous Effects]

An organic solar cell according to an exemplary embodiment of the present specification may exhibit excellent characteristics in terms of efficiency, stability, processability, and the like by simultaneously using a single molecular material having reproducibility and a simple process and a polymer material having excellent efficiency as an electron donor of a photoactive layer.

### [Brief Description of Drawings]

FIG. 1 is a view illustrating an organic solar cell according to an exemplary embodiment of the present specification.
FIG. 2 is a view illustrating gel permeation chromatography (GPC) for a prepared polymer.
FIG. 3 is a view illustrating current-voltage curves of the organic solar cells prepared in the Examples and the Comparative Example of the present specification.
FIG. 4 is a view illustrating the changes in V_{oc}, J_{sc}, FF, and efficiency over time with respect to the organic solar cell prepared in Comparative Example 1 of the present specification.
FIG. 5 is a view illustrating the changes in V_{oc}, J_{sc}, FF, and efficiency over time with respect to the organic solar cell prepared in Example 1 of the present specification.
FIG. 6 is a view illustrating the changes in V_{oc}, J_{sc}, FF, and efficiency over time with respect to the organic solar cell prepared in Example 2 of the present specification.
   - 101:: Substrate
   - 102:: First electrode
   - 103:: Hole transport layer
   - 104:: Photoactive layer
   - 105:: Second electrode

### [Best Mode]

Hereinafter, the present specification will be described in detail.

When one part "includes" one constituent element in the present specification, unless otherwise specifically described, this does not mean that another constituent element is excluded, but means that another constituent element may be further included.

When one member is disposed "on" another member in the present specification, this includes not only a case where the one member is brought into contact with another member, but also a case where still another member is present between the two members.

In the present specification, the "structure in the parenthesis" means a structure included in the ( ).

In the present specification, the "unit" means a repeated structure included in a monomer of a copolymer, and a structure in which the monomer is bonded into the copolymer by polymerization.

In the present specification, the meaning of "including a unit" means that the unit is included in a main chain in a polymer.

An exemplary embodiment of the present specification provides a photoactive layer including: an electron donor; and an electron acceptor,
in which the electron donor includes: a single molecular material; and a polymer material,
a content of the electron donor is higher than a content of the electron acceptor, and
in the electron donor, a content of the single molecular material is higher than a content of the polymer material,
wherein the polymer material is a copolymer comprising a unit represented by the following Formula 2: 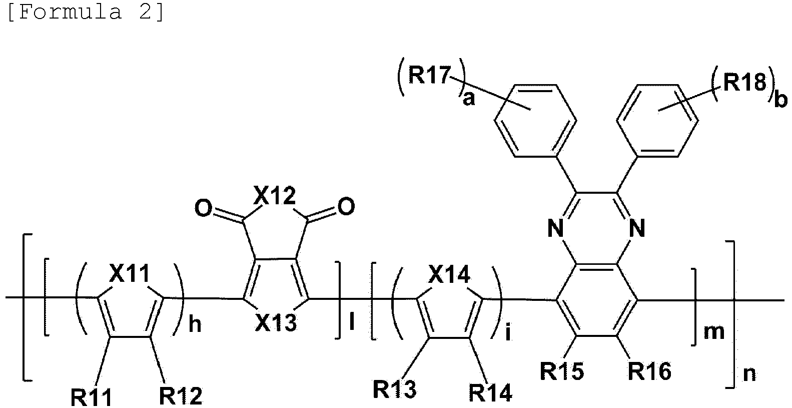 in Formula 2,
   1 is a molar fraction, and a real number of 0 < 1 ≤ 1,
   m is a molar fraction, and a real number of 0 < 1 ≤ 1,
   1 + m = 1,
   h and i are each an integer from 1 to 3,
   when h and i are 2 or more, the structures in the parenthesis are the same as or different from each other,
   n is an integer from 1 to 10,000,
   a and b are each an integer from 1 to 5,
   X11 to X14 are the same as or different from each other, and are each independently CRR', NR, O, SiRR', PR, S, GeRR', Se, and Te, and
   R11 to R18, R, and R' are the same as or different from each other, and are each independently hydrogen; deuterium; a halogen group; a nitrile group; a nitro group; an imide group; an amide group; a hydroxyl group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted alkylamine group; a substituted or unsubstituted aralkylamine group; a substituted or unsubstituted arylamine group; a substituted or unsubstituted heteroarylamine group; a substituted or unsubstituted aryl group; a substituted or unsubstituted fluorenyl group; a substituted or unsubstituted carbazole group; and a substituted or unsubstituted heterocyclic group.

In the present specification, when the content of the electron donor is higher than that of the electron acceptor, there is an effect in that the efficiency is increased.

In the present specification, in the electron donor, when the content of the single molecular material is higher than the content of the polymer material, there is an effect in that the efficiency is increased.

In the present specification, a difference in content means a difference in weight.

In the present specification, the "polymer" means a polymer in which the same structure is repeated. That is, the "polymer" means a polymer in which a repeating unit is present.

In an exemplary embodiment of the present specification, the polymer material has a number average molecular weight of 2,000 g/mol to 30,000,000 g/mol. Specifically, the polymer material has a number average molecular weight of 10,000 g/mol to 3,000,000 g/mol. More specifically, the polymer material has a number average molecular weight of 10,000 g/mol to 100,000 g/mol.

In the present specification, the "single molecule" means a material composed of one structure having no repeating unit.

In an exemplary embodiment of the present specification, the single molecular material has a molecular weight of 1,000 g/mol to 10,000,000 g/mol. Specifically, the single molecular material has a molecular weight of 1,000 g/mol to 9,000 g/mol.

In an exemplary embodiment of the present specification, a weight ratio of the electron donor to the electron acceptor may be 10 : 1 to 1.1 : 1. More specifically, a weight ratio of the electron donor to the electron acceptor may be 5 : 1 to 1.1 : 1.

When the weight ratio of the electron donor to the electron acceptor satisfies the above range, there is an effect in that the efficiency and the stability are increased.

In an exemplary embodiment of the present specification, the content of the single molecular material in the electron donor is higher than that of the polymer material in the electron donor. Specifically, in an exemplary embodiment of the present specification, a weight ratio of the single molecular material to the polymer material in the electron donor is 30 : 1 to 2 : 1. More specifically, a weight ratio of the single molecular material to the polymer material in the electron donor is 20 : 1 to 5 : 1. When the weight ratio of the single molecular material to the polymer material satisfies the above range, there is an effect in that the efficiency is increased.

Examples of the substituents in the present specification will be described below, but are not limited thereto.

The term "substitution" means that a hydrogen atom bonded to a carbon atom of a compound is changed into another substituent, and a position to be substituted is not limited as long as the position is a position at which the hydrogen atom is substituted, that is, a position at which the substituent may be substituted, and when two or more are substituted, the two or more substituents may be the same as or different from each other.

In the present specification, the term "substituted or unsubstituted" means being substituted with one or two or more substituents selected from the group consisting of deuterium; a halogen group; a nitrile group; a nitro group; an imide group; an amide group; a carbonyl group; an ester group; a hydroxyl group; an alkyl group; a cycloalkyl group; an alkoxy group; an aryloxy group; an alkylthioxy group; an arylthioxy group; an alkylsulfoxy group; an arylsulfoxy group; an alkenyl group; a silyl group; a siloxane group; a boron group; an amine group; an arylphosphine group; a phosphine oxide group; an aryl group; and a heterocyclic group, or being substituted with a substituent to which two or more substituents among the exemplified substituents are linked, or having no substituent. For example, "the substituent to which two or more substituents are linked" may be a biphenyl group. That is, the biphenyl group may also be an aryl group, and may be interpreted as a substituent to which two phenyl groups are linked.

In the present specification, a halogen group may be fluorine, chlorine, bromine or iodine.

In the present specification, the number of carbon atoms of an imide group is not particularly limited, but is preferably 1 to 30.

In the present specification, for an amide group, the nitrogen of the amide group may be substituted with hydrogen, a straight-chained, branched, or cyclic alkyl group having 1 to 30 carbon atoms, or an aryl group having 6 to 30 carbon atoms.

In the present specification, the number of carbon atoms of a carbonyl group is not particularly limited, but is preferably 1 to 30.

In the present specification, for an ester group, the oxygen of the ester group may be substituted with a straight-chained, branched, or cyclic alkyl group having 1 to 25 carbon atoms, or an aryl group having 6 to 30 carbon atoms.

In the present specification, the alkyl group may be straight-chained or branched, and the number of carbon atoms thereof is not particularly limited, but is preferably 1 to 30. Specific examples thereof include methyl, ethyl, propyl, n-propyl, isopropyl, butyl, n-butyl, isobutyl, tert-butyl, sec-butyl, 1-methyl-butyl, 1-ethylbutyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethyl-propyl, isohexyl, 4-methylhexyl, 5-methylhexyl, and the like, but are not limited thereto.

In the present specification, a cycloalkyl group is not particularly limited, but has preferably 3 to 30 carbon atoms, and specific examples thereof include cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, cyclooctyl, and the like, but are not limited thereto.

In the present specification, the alkoxy group may be straight-chained, branched, or cyclic. The number of carbon atoms of the alkoxy group is not particularly limited, but is preferably 1 to 30. Specific examples thereof include methoxy, ethoxy, n-propoxy, isopropoxy, i-propyloxy, n-butoxy, isobutoxy, tert-butoxy, sec-butoxy, n-pentyloxy, neopentyloxy, isopentyloxy, n-hexyloxy, 3,3-dimethylbutyloxy, 2-ethylbutyloxy, n-octyloxy, n-nonyloxy, n-decyloxy, benzyloxy, p-methylbenzyloxy, and the like, but are not limited thereto.

In the present specification, an amine group may be selected from the group consisting of -NH₂; an alkylamine group; an N-arylalkylamine group; an arylamine group; an N-arylheteroarylamine group; an N-alkylheteroarylamine group; and a heteroarylamine group, and the number of carbon atoms thereof is not particularly limited, but is preferably 1 to 30. Specific examples of the amine group include a methylamine group, a dimethylamine group, an ethylamine group, a diethylamine group, a phenylamine group, a naphthylamine group, a biphenylamine group, an anthracenylamine group, a 9-methyl-anthracenylamine group, a diphenylamine group, an N-phenylnaphthylamine group, a ditolylamine group, an N-phenyltolylamine group, a triphenylamine group, and the like, but are not limited thereto.

In the present specification, an N-alkylarylamine group means an amine group in which a N of the amine group are substituted with an alkyl group and an aryl group.

In the present specification, an N-arylheteroarylamine group means an amine group in which a N of the amine group are substituted with an aryl group and a heteroaryl group.

In the present specification, an N-alkylheteroarylamine group means an amine group in which a N of the amine group are substituted with alkyl group and a heteroaryl group.

In the present specification, the alkyl group in the alkylamine group, the N-arylalkylamine group, the alkylthioxy group, the alkylsulfoxy group, and the N-alkylheteroarylamine group is the same as the above-described examples of the alkyl group. Specifically, examples of the alkylthioxy group include a methylthioxy group, an ethylthioxy group, a tert-butylthioxy group, a hexylthioxy group, an octylthioxy group, and the like, and examples of the alkylsulfoxy group include methyl, an ethylsulfoxy group, a propylsulfoxy group, a butylsulfoxy group, and the like, but the examples are not limited thereto.

In the present specification, the alkenyl group may be straight-chained or branched, and the number of carbon atoms thereof is not particularly limited, but is preferably 2 to 30. Specific examples thereof include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, a stilbenyl group, a styrenyl group, and the like, but are not limited thereto.

In the present specification, specific examples of a silyl group include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, and the like, but are not limited thereto.

In the present specification, a boron group may be-BR₁₀₀R₂₀₀, and R₁₀₀ and R₂₀₀ are the same as or different from each other, and may be each independently selected from the group consisting of hydrogen; deuterium; halogen; a nitrile group; a substituted or unsubstituted monocyclic or polycyclic cycloalkyl group having 3 to 30 carbon atoms; a substituted or unsubstituted straight-chained or branched alkyl group having 1 to 30 carbon atoms; a substituted or unsubstituted monocyclic or polycyclic aryl group having 6 to 30 carbon atoms; and a substituted or unsubstituted monocyclic or polycyclic heteroaryl group having 2 to 30 carbon atoms.

In the present specification, specific examples of a phosphine oxide group include a diphenylphosphine oxide group, dinaphthylphosphine oxide, and the like, but are not limited thereto.

In the present specification, an aryl group may be monocyclic or polycyclic.

When the aryl group is a monocyclic aryl group, the number of carbon atoms thereof is not particularly limited, but is preferably 6 to 30. Specific examples of the monocyclic aryl group include a phenyl group, a biphenyl group, a terphenyl group, and the like, but are not limited thereto.

When the aryl group is a polycyclic aryl group, the number of carbon atoms thereof is not particularly limited, but is preferably 10 to 30. Specific examples of the polycyclic aryl group include a naphthyl group, an anthracenyl group, a phenanthryl group, a pyrenyl group, a perylenyl group, a chrysenyl group, a fluorenyl group, and the like, but are not limited thereto.

In the present specification, the fluorenyl group may be substituted, and adjacent substituents may be bonded to each other to form a ring.

When the fluorenyl group is substituted, the fluorenyl group may be 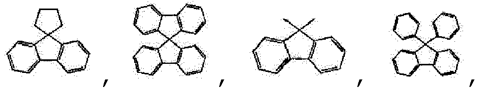 and the like. However, the fluorenyl group is not limited thereto.

In the present specification, the aryl group in the aryloxy group, the arylthioxy group, the arylsulfoxy group, the N-arylalkylamine group, the N-arylheteroarylamine group, and the arylphosphine group is the same as the above-described examples of the aryl group. Specifically, examples of the aryloxy group include a phenoxy group, a p-tolyloxy group, an m-tolyloxy group, a 3,5-dimethyl-phenoxy group, a 2,4,6-trimethylphenoxy group, a p-tert-butylphenoxy group, a 3-biphenyloxy group, a 4-biphenyloxy group, a 1-naphthyloxy group, a 2-naphthyloxy group, a 4-methyl-1-naphthyloxy group, a 5-methyl-2-naphthyloxy group, a 1-anthryloxy group, a 2-anthryloxy group, a 9-anthryloxy group, a 1-phenanthryloxy group, a 3-phenanthryloxy group, a 9-phenanthryloxy group, and the like, examples of the arylthioxy group include a phenylthioxy group, a 2-methylphenylthioxy group, a 4-tert-butylphenylthioxy group, and the like, and examples of the arylsulfoxy group include a benzenesulfoxy group, a p-toluenesulfoxy group, and the like, but the examples are not limited thereto.

In the present specification, examples of the arylamine group include a substituted or unsubstituted monoarylamine group, a substituted or unsubstituted diarylamine group, or a substituted or unsubstituted triarylamine group. The aryl group in the arylamine group may be a monocyclic aryl group or a polycyclic aryl group. The arylamine group including two or more aryl groups may include a monocyclic aryl group, a polycyclic aryl group, or both a monocyclic aryl group and a polycyclic aryl group. For example, the aryl group in the arylamine group may be selected from the above-described examples of the aryl group.

In the present specification, a heterocyclic group includes one or more atoms other than carbon, that is, one or more heteroatoms, and specifically, the heteroatom may include one or more atoms selected from the group consisting of O, N, Se, S, and the like. The number of carbon atoms thereof is not particularly limited, but is preferably 2 to 30, and the heterocyclic group may be monocyclic or polycyclic. Examples of the heterocyclic group include a thiophene group, a furanyl group, a pyrrole group, an imidazolyl group, a thiazolyl group, an oxazolyl group, an oxadiazolyl group, a pyridyl group, a bipyridyl group, a pyrimidyl group, a triazinyl group, a triazolyl group, an acridyl group, a pyridazinyl group, a pyrazinyl group, a quinolinyl group, a quinazolinyl group, a quinoxalinyl group, a phthalazinyl group, a pyridopyrimidyl group, a pyridopyrazinyl group, a pyrazinopyrazinyl group, an isoquinolinyl group, an indolyl group, a carbazolyl group, a benzoxazolyl group, a benzimidazolyl group, a benzothiazolyl group, a benzocarbazolyl group, a benzothiophene group, a dibenzothiophene group, a benzofuranyl group, a phenanthrolinyl group (phenanthroline), a thiazolyl group, an isoxazolyl group, an oxadiazolyl group, a thiadiazolyl group, a phenothiazinyl group, a dibenzofuranyl group, and the like, but are not limited thereto.

In the present specification, examples of the heteroarylamine group include a substituted or unsubstituted monoheteroarylamine group, a substituted or unsubstituted diheteroarylamine group, or a substituted or unsubstituted triheteroarylamine group. The heteroarylamine group including two or more heteroaryl groups may include a monocyclic heteroaryl group, a polycyclic heteroaryl group, or both a monocyclic heteroaryl group and a polycyclic heteroaryl group. For example, the heteroaryl group in the heteroarylamine group may be selected from the above-described examples of the heterocyclic group.

In an exemplary embodiment of the present specification, the electron acceptor includes a fullerene derivative.

In the present specification, the "fullerene derivative" means a material having one or more spherical shell structures in which a molecule is formed of carbon. Examples thereof include: a fullerene as a molecule having a spherical shell shape; a fullerene derivative having an inorganic group or an organic group, which is bonded to a fullerene comprising carbon; a fullerene derivative to which a spherical shell structure constituting a fullerene or the fullerene derivative is bonded directly or through one or more elements; and the like.

In an exemplary embodiment of the present specification, the fullerene means a molecule in which a carbon atom is linked in the form of a soccer ball composed of pentagons and hexagons, and is C₆₀ to C₉₀. More specifically, the fullerene is C₆₀.

In an exemplary embodiment of the present specification, the fullerene derivative is [6,6]-phenyl-C₆₁-butyric acid methyl ester (PC₆₁BM), [6,6]-phenyl-C₇₁-butyric acid methyl ester) (PC₇₁BM), phenyl-C₆₁-butyric acid cholesteryl ester (PCBCR), or 1',1'',4 ',4 ''-tetrahydro-di[1,4]methanonaphthaleno[1,2:2',3',56,60:2'',3''][5,6]full erene-C₆₀ (ICBA).

In an exemplary embodiment of the present specification, the electron acceptor may also include an organic material, which is not fullerene series, such as 3,9-bis(2-methylene-(3-(1,1-dicyanomethylene)-indanone))-5,5,11,11-tetrakis(4-hexylphenyl)-dithieno[2,3-d:2',3'-d']-s-indaceno[1,2-b:5,6-b']dithiophene (ITIC).

In an exemplary embodiment of the present specification, the single molecular material is a compound represented by the following Formula 1.

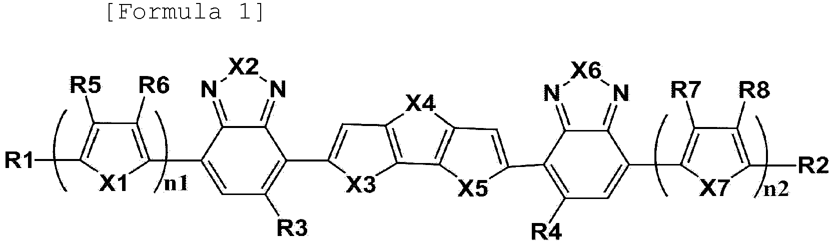

In Formula 1,
n1 and n2 are each an integer from 1 to 3,
when n1 and n2 are 2 or more, the structures in the parenthesis are the same as or different from each other,
X1 to X7 are the same as or different from each other, and are each independently CRR', NR, O, SiRR', PR, S, GeRR', Se, and Te, and
R1 to R8, R, and R' are the same as or different from each other, and are each independently hydrogen; deuterium; a halogen group; a nitrile group; a nitro group; a hydroxyl group; a carbonyl group; an ester group; an imide group; an amide group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted amine group; a substituted or unsubstituted arylphosphine group; a substituted or unsubstituted phosphine oxide group; a substituted or unsubstituted aryl group; or a substituted or unsubstituted heterocyclic group.

In an exemplary embodiment of the present specification, R1 to R8 are the same as or different from each other, and are each independently hydrogen; a halogen group; a substituted or unsubstituted alkyl group; a substituted or unsubstituted aryl group; or a substituted or unsubstituted heterocyclic group.

In an exemplary embodiment of the present specification, R1 to R8 are the same as or different from each other, and are each independently hydrogen; a halogen group; or a substituted or unsubstituted alkyl group.

In an exemplary embodiment of the present specification, R1 and R2 are the same as or different from each other, and are each independently a substituted or unsubstituted alkyl group.

In an exemplary embodiment of the present specification, R1 and R2 are the same as or different from each other, and are each independently an alkyl group having 1 to 30 carbon atoms.

In an exemplary embodiment of the present specification, R1 and R2 are the same as or different from each other, and are each independently an alkyl group having 1 to 20 carbon atoms.

In an exemplary embodiment of the present specification, R1 and R2 are the same as or different from each other, and are each independently an alkyl group having 1 to 10 carbon atoms.

In an exemplary embodiment of the present specification, R3 and R4 are the same as or different from each other, and are each independently a halogen group.

In an exemplary embodiment of the present specification, R3 and R4 are each fluorine.

In an exemplary embodiment of the present specification, R5 to R8 are each hydrogen.

In an exemplary embodiment of the present specification, X1 to X7 are the same as or different from each other, and are each independently CRR', NR, O, SiRR', or S, and R and R' are the same as those described above.

In an exemplary embodiment of the present specification, X1 to X7 are the same as or different from each other, and are each independently SiRR' or S, and R and R' are the same as those described above.

In an exemplary embodiment of the present specification, X1 to X7 are the same as or different from each other, and are each independently SiRR' or S, and R and R' are a substituted or unsubstituted alkyl group.

In an exemplary embodiment of the present specification, X1 to X3 and X5 to X7 are S.

In an exemplary embodiment of the present specification, X4 is SiRR', and R and R' are a substituted or unsubstituted alkyl group.

In an exemplary embodiment of the present specification, X4 is SiRR', and R and R' are a straight-chained or branched alkyl group having 1 to 30 carbon atoms.

In an exemplary embodiment of the present specification, X4 is SiRR', and R and R' are a straight-chained or branched alkyl group having 1 to 20 carbon atoms.

In an exemplary embodiment of the present specification, n1 and n2 are 1.

In an exemplary embodiment of the present specification, n1 and n2 are 2.

In an exemplary embodiment of the present specification, n1 and n2 are 3.

The polymer material is a copolymer including a unit represented by the following Formula 2.

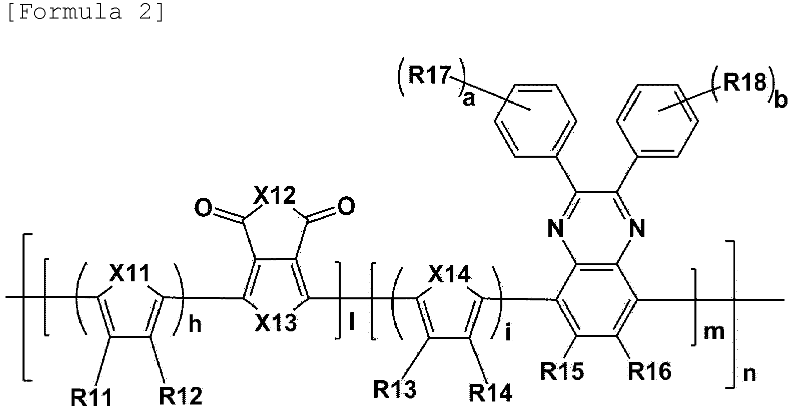

In Formula 2,
1 is a molar fraction, and a real number of 0 < 1 ≤ 1,
m is a molar fraction, and a real number of 0 < 1 ≤ 1,
1 + m = 1,
h and i are each an integer from 1 to 3,
when h and i are 2 or more, the structures in the parenthesis are the same as or different from each other,
n is an integer from 1 to 10,000,
a and b are each an integer from 1 to 5,
X11 to X14 are the same as or different from each other, and are each independently CRR', NR, O, SiRR', PR, S, GeRR', Se, and Te, and
R11 to R18, R, and R' are the same as or different from each other, and are each independently hydrogen; deuterium; a halogen group; a nitrile group; a nitro group; an imide group; an amide group; a hydroxyl group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted alkylamine group; a substituted or unsubstituted aralkylamine group; a substituted or unsubstituted arylamine group; a substituted or unsubstituted heteroarylamine group; a substituted or unsubstituted aryl group; a substituted or unsubstituted fluorenyl group; a substituted or unsubstituted carbazole group; and a substituted or unsubstituted heterocyclic group.

According to an exemplary embodiment of the present specification, a number average molecular weight of the copolymer is 2,000 g/mol to 30,000,000 g/mol. Preferably, the number average molecular weight thereof is 10,000 g/mol to 3,000,000 g/mol. More preferably, the number average molecular weight thereof is 10,000 g/mol to 100,000 g/mol.

According to an exemplary embodiment of the present specification, the copolymer may have a molecular weight distribution of 1 to 100. Preferably, the copolymer has a molecular weight distribution of 1 to 3.

The lower the molecular weight distribution is and the larger the number average molecular weight is, the better electric characteristics and mechanical characteristics become, and it is preferred that the number average molecular weight of the copolymer is 100,000 g/mol or less, such that the copolymer has solubility at a certain level or more, and thus is advantageously applied to a solution application method.

In an exemplary embodiment of the present specification, R11 to R18 are the same as or different from each other, and are each independently hydrogen; a halogen group; a substituted or unsubstituted alkyl group; a substituted or unsubstituted alkoxy group; a substituted or unsubstituted aryl group; or a substituted or unsubstituted heterocyclic group.

In an exemplary embodiment of the present specification, R11 to R18 are the same as or different from each other, and are each independently hydrogen; a halogen group; a substituted or unsubstituted alkyl group; or a substituted or unsubstituted alkoxy group.

In an exemplary embodiment of the present specification, R11 to R14 are each hydrogen.

In an exemplary embodiment of the present specification, R15 and R16 are the same as or different from each other, and are each independently a halogen group.

In an exemplary embodiment of the present specification, R15 and R16 are each fluorine.

In an exemplary embodiment of the present specification, R17 and R18 are the same as or different from each other, and are each independently a substituted or unsubstituted alkoxy group.

In an exemplary embodiment of the present specification, X11 to X14 are the same as or different from each other, and are each independently CRR', NR, O, SiRR', or S, and R and R' are the same as those described above.

In an exemplary embodiment of the present specification, X11, X13, and X14 are each S.

In an exemplary embodiment of the present specification, X12 is NR, and R is a substituted or unsubstituted alkyl group.

In an exemplary embodiment of the present specification, X12 is NR, and R is an alkyl group having 1 to 30 carbon atoms.

In an exemplary embodiment of the present specification, X12 is NR, and R is an alkyl group having 1 to 20 carbon atoms.

In an exemplary embodiment of the present specification, 1 : m is 0.2 : 0.8 to 0.8 : 0.2.

In an exemplary embodiment of the present specification, 1 : m is 0.4 : 0.6 to 0.6 : 0.4.

In an exemplary embodiment of the present specification, 1 and m are each 0.5.

In an exemplary embodiment of the present specification, h and i are 1.

In an exemplary embodiment of the present specification, n is an integer from 2 to 10,000.

In an exemplary embodiment of the present specification, a is 1.

In an exemplary embodiment of the present specification, b is 1.

In an exemplary embodiment of the present specification, an end group of the copolymer is selected from the group consisting of hydrogen; deuterium; a halogen group; a nitrile group; a nitro group; an imide group; an amide group; a hydroxyl group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted alkylamine group; a substituted or unsubstituted aralkylamine group; a substituted or unsubstituted arylamine group; a substituted or unsubstituted heteroarylamine group; a substituted or unsubstituted aryl group; and a substituted or unsubstituted heterocyclic group.

In an exemplary embodiment of the present specification, the end group of the copolymer is a substituted or unsubstituted aryl group; or a substituted or unsubstituted heterocyclic group.

In an exemplary embodiment of the present specification, the end group of the copolymer is a 4-(trifluoromethyl)phenyl group.

An exemplary embodiment of the present specification provides an organic solar cell including: a first electrode;
a second electrode provided to face the first electrode; and
an organic material layer having one or more layers provided between the first electrode and the second electrode and including the above-described photoactive layer.

In an exemplary embodiment of the present specification, the organic solar cell may further include an additional organic material layer. The organic solar cell may reduce the number of organic material layers by using an organic material which simultaneously has various functions.

In an exemplary embodiment of the present specification, the organic solar cell includes a first electrode, a photoactive layer according to claim 1, and a second electrode provided to face the first electrode. The organic solar cell may further include a substrate, a hole transport layer, and/or an electron transport layer.

The photoactive layer includes the single molecular material and the polymer material.

In an exemplary embodiment of the present specification, the organic material layer further includes a hole transport layer, a hole injection layer, or a layer which simultaneously transports and injects holes.

In another exemplary embodiment, the organic material layer further includes an electron injection layer, an electron transport layer, or a layer which simultaneously injects and transports electrons.

In an exemplary embodiment of the present specification, when the organic solar cell accepts a photon from an external light source, an electron and a hole are generated between an electron donor and an electron acceptor. The generated hole is transported to a positive electrode through an electron donor.

In an exemplary embodiment of the present specification, the first electrode is a positive electrode, and the second electrode is a negative electrode. In another exemplary embodiment of the present specification, the first electrode is a negative electrode, and the second electrode is a positive electrode.

In an exemplary embodiment of the present specification, an organic solar cell may be arranged in an order of a first electrode, a photoactive layer according to claim 1, and a second electrode based on a light source, and may be arranged in an order of a second electrode, a photoactive layer according to claim 1, and a first electrode based on a light source, but the arrangement order is not limited thereto.

In another exemplary embodiment, in the organic solar cell, a positive electrode, a hole transport layer, a photoactive layer according to claim 1, an electron transport layer, and a negative electrode may also be arranged in this order, and a negative electrode, an electron transport layer, a photoactive layer according to claim 1, a hole transport layer, and a positive electrode may also be arranged in this order, but the arrangement order is not limited thereto.

In an exemplary embodiment of the present specification, the electron donor and the electron acceptor constitute a bulk heterojunction (BHJ).

In the present specification, the substrate may be a glass substrate or a transparent plastic substrate having excellent transparency, surface smoothness, ease of handling, and waterproofing properties, but is not limited thereto, and the substrate is not limited as long as the substrate is typically used in the organic solar cell. Specific examples thereof include glass or polyethylene terephthalate (PET), polyethylene naphthalate (PEN), polypropylene (PP), polyimide (PI), triacetyl cellulose (TAC), and the like, but are not limited thereto.

The first electrode may be a material which is transparent and has excellent conductivity, but is not limited thereto. Examples thereof include: a metal such as vanadium, chromium, copper, zinc, and gold, or an alloy thereof; a metal oxide such as zinc oxide, indium oxide, indium tin oxide (ITO), and indium zinc oxide (IZO); a combination of a metal and an oxide, such as ZnO:Al or SnO₂:Sb; a conductive polymer, such as poly(3-methylthiophene), poly[3,4-(ethylene-1,2-dioxy)thiophene] (PEDOT), polypyrrole, and polyaniline; and the like, but are not limited thereto.

A method of forming the first electrode is not particularly limited, but the first electrode may be formed, for example, by being applied onto one surface of a substrate using a method such as sputtering, e-beam, thermal deposition, spin coating, screen printing, inkjet printing, doctor blade, or gravure printing, or by being coated in the form of a film.

When the first electrode is formed on a substrate, the first electrode may be subjected to processes of cleaning, removing moisture, and hydrophilic modification.

For example, a patterned ITO substrate is sequentially cleaned with a cleaning agent, acetone, and isopropyl alcohol (IPA), and then dried on a hot plate at 100°C to 150°C for 1 to 30 minutes, preferably at 120°C for 10 minutes in order to remove moisture, and when the substrate is completely cleaned, the surface of the substrate is hydrophilically modified.

Through the surface modification as described above, the junction surface potential may be maintained at a level suitable for a surface potential of a photoactive layer. Further, during the modification, a polymer thin film may be easily formed on the first electrode, and the quality of the thin film may also be improved.

Examples of a pre-treatment technology for the first electrode include a) a surface oxidation method using a parallel flat plate-type discharge, b) a method of oxidizing the surface through ozone produced by using UV rays in a vacuum state, c) an oxidation method using oxygen radicals produced by plasma, and the like.

One of the methods may be selected according to the state of the first electrode or the substrate. However, although any method is used, it is preferred to commonly prevent oxygen from being separated from the surface of the first electrode or the substrate, and maximally inhibit moisture and organic materials from remaining. In this case, it is possible to maximize a substantial effect of the pre-treatment.

As a specific example, it is possible to use a method of oxidizing the surface through ozone produced by using UV. In this case, a patterned ITO substrate after being ultrasonically cleaned is baked on a hot plate and dried well, and then introduced into a chamber, and the patterned ITO substrate may be cleaned by ozone generated by allowing an oxygen gas to react with UV light by operating a UV lamp.

However, the surface modification method of the patterned ITO substrate in the present specification need not be particularly limited, and any method may be used as long as the method is a method of oxidizing a substrate. The second electrode may be a metal having a low work function, but is not limited thereto. Specific examples thereof include: a metal such as magnesium, calcium, sodium, potassium, titanium, indium, yttrium, lithium, gadolinium, aluminum, silver, tin, and lead, or an alloy thereof; and a multi-layer structured material, such as LiF/Al, LiO₂/Al, LiF/Fe, Al:Li, Al:BaF₂, and Al:BaF₂:Ba, but are not limited thereto.

The second electrode may be deposited and formed in a thermal evaporator showing a vacuum degree of 5 × 10⁻⁷ torr or less, but the forming method is not limited to this method.

A material for the hole transport layer and/or a material for the electron transport layer serve to efficiently transfer electrons and holes separated from a photoactive layer to an electrode, and the materials are not particularly limited.

The material for the hole transport layer may be poly(3,4-ethylenedioxythiophene) doped with poly(styrenesulfonic acid) (PEDOT:PSS) and molybdenum oxide (MoOₓ); vanadium oxide (V₂O₅); nickel oxide (NiO); tungsten oxide (WOₓ); and the like, but is not limited thereto.

The material for the electron transport layer may be electron-extracting metal oxides, and specific examples thereof include: metal complexes of 8-hydroxyquinoline; complexes including Alq₃; metal complexes including Liq; LiF; Ca; titanium oxide (TiOₓ); zinc oxide (ZnO); cesium carbonate (Cs₂CO₃); and the like, but are not limited thereto.

The photoactive layer may be formed by dissolving a photoactive material such as an electron donor and/or an electron acceptor in an organic solvent, and then applying the solution by a method such as spin coating, dip coating, screen printing, spray coating, doctor blade, and brush painting, but the forming method is not limited thereto.

### [Mode for Invention]

A preparation method of the photoactive layer and the manufacture of an organic solar cell including the same will be described in detail in the following Preparation Examples and Examples. However, the following Examples are provided for exemplifying the present specification, and the scope of the present specification is not limited thereby.

### Preparation Example 1. Polymerization of Polymer

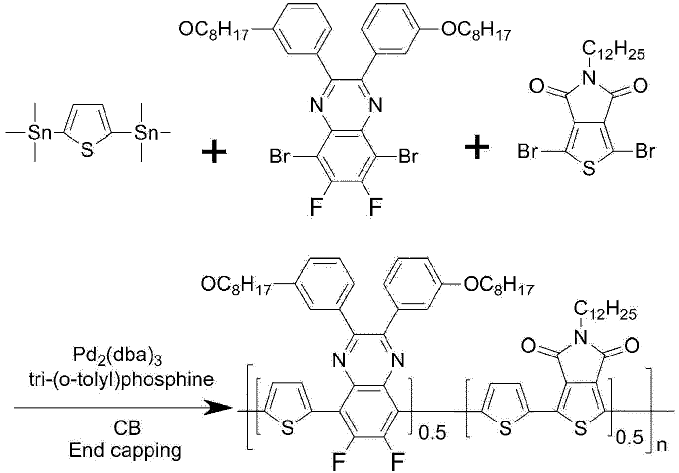

13 ml of chlorobenzene, 2,5-bis(trimethylstannyl)thiophene (1.2 g, 2.92 mmol), 5,8-dibromo-2,3-bis(3-(octyloxy)phenyl)quinoxaline (0.9905 g, 1.46 mmol), 1,3-dibromo-5-dodecylthieno[3,4-c]pyrrole-4,6-dione (0.7018 g, 1.46 mmol), tris(dibenzylideneacetone)dipalladium(0) (Pd₂(dba)₃, 80 mg), and tri-(o-tolyl)phosphine (106 mg) were put into a microwave reactor vial, and allowed to react under a condition of 170°C for 1 hour. After the mixture was cooled to room temperature and poured into methanol, the solid was filtered and subjected to soxhlet extraction in methanol, acetone, hexane, and chloroform, and then the chloroform part was precipitated again in methanol and the solid was filtered out.
Yield: 60%
Number average molecular weight: 26,300 g/mol
Weight average molecular weight: 78,300 g/mol

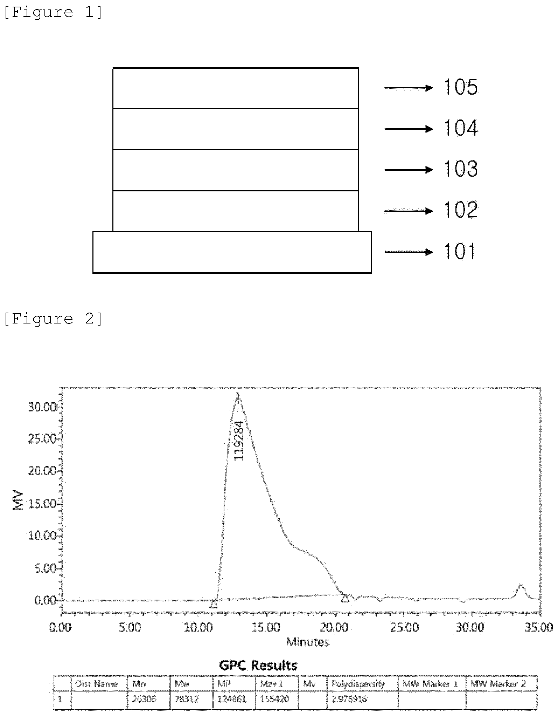

FIG. 2 is a view illustrating gel permeation chromatography (GPC) for the prepared polymer.

Manufacture of Organic Solar Cell and Measurement of Characteristics Thereof

### Example 1.

First and second composite solutions were prepared by dissolving each of a single molecule (p-DTS(FBTTH₂)₂, 1-Material Co., Ltd.) having the following structure and the polymer prepared in the Preparation Example with PC₇₁BM at a weight ratio of 3 : 2 in chlorobenzene (CB) at a concentration of 2.0 wt%. The first and second composite solutions were mixed at a ratio of 2.85 : 0.15, thereby preparing a third composite solution such that the weight ratio of the single molecule : the polymer : PCBM as a whole was 2.85 : 0.15 : 2. In this case, an organic solar cell was made to have a structure of ITO/ZnO/a photoactive layer/MoO₃/Ag. A glass substrate coated with ITO was ultrasonically washed using distilled water, acetone, and 2-propanol, and the ITO surface was treated with ozone for 10 minutes, followed by spin-coating ZnO and a heat treatment at 230°C for 1 hour. The third composite solution was filtered with a 0.45 µm PP syringe filter in order to coat the photoactive layer, and then spin-coated, MoO₃ was deposited by using a thermal evaporator under high vacuum, and Ag was deposited to a thickness of 100 nm thereon, thereby manufacturing an organic solar cell.

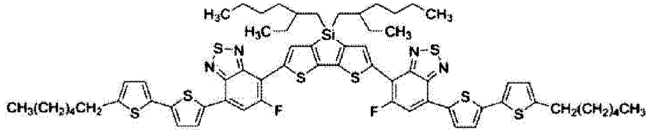

### Example 2.

After first and second composite solutions were prepared by dissolving each of a single molecule (p-DTS(FBTTH₂)₂, 1-Material Co., Ltd.) and the polymer prepared in the Preparation Example with PCBM at a weight ratio of 3 : 2 in chlorobenzene (CB) at a concentration of 2.0 wt%, the first and second composite solutions were mixed such that the weight ratio of the single molecule : the polymer : PCBM was 2.70 : 0.30 : 2, thereby preparing a fourth composite solution. An organic solar cell was manufactured in the same manner as in Example 1, except that the fourth composite solution was applied to the photoactive layer.

### Comparative Example 1.

A composite solution was prepared by dissolving a single molecule (p-DTS(FBTTH₂)₂, 1-Material Co., Ltd.) and PCBM at a weight ratio of 3 : 2 in chlorobenzene (CB). An organic solar cell was manufactured in the same manner as in Example 1, except that the composite solution was applied to the photoactive layer.

### Comparative Example 2.

A composite solution was prepared by dissolving the polymer and PCBM at a weight ratio of 1 : 2 in chlorobenzene (CB). An organic solar cell was manufactured in the same manner as in Example 1, except that the composite solution was applied to the photoactive layer.

### Comparative Example 3.

After first and second composite solutions were prepared by dissolving each of a single molecule (p-DTS(FBTTH₂)₂, 1-Material Co., Ltd.) and the polymer prepared in the Preparation Example with PCBM at a weight ratio of 3 : 2 in chlorobenzene (CB) at a concentration of 2.0 wt%, the first and second composite solutions were mixed such that the weight ratio of the single molecule : the polymer : PCBM was 0.15 : 2.85 : 2, thereby preparing a fifth composite solution. An organic solar cell was manufactured in the same manner as in Example 1, except that the fifth composite solution was applied to the photoactive layer.

Photoelectric conversion characteristics of the organic solar cells manufactured in Examples 1 and 2 and Comparative Examples 1 to 3 were measured under conditions (1SUN conditions) of 100 mV/cm² (AM 1.5), and the results thereof are shown in the following Table 1.

**[Table 1]**

| | Photoactive layer (Weight ratio of single molecule : polymer : electron acceptor) | PCE (%) |
|---|---|---|
| Example 1 | 2.85:0.15:2 | 6.75 |
| Example 2 | 2.70:0.30:2 | 6.36 |
| Comparative Example 1 | 3:0:2 | 5.11 |
| Comparative Example 2 | 0:1:2 | 4.75 |
| Comparative Example 3 | 0.15:2.85:2 | 1.98 |

In Table 1, the PCE means an energy conversion efficiency, and a higher value is preferred.

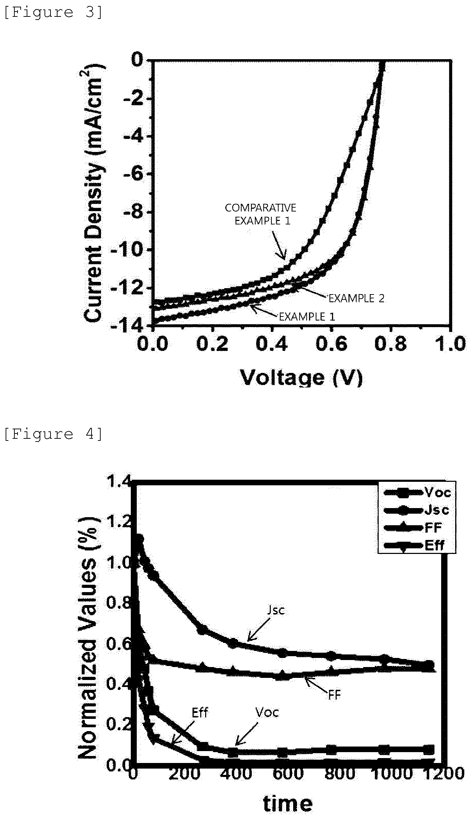

FIG. 3 is a view illustrating current-voltage curves of the organic solar cells prepared in the Examples and the Comparative Example of the present specification.

With respect to the organic solar cells manufactured in the Examples and the Comparative Examples, the changes in efficiency over time under the 1SUN conditions were measured and normalized, and the results thereof are shown in the following Table 2.

**[Table 2]**

| Time (h) | Example 1 | Example 2 | Comparative Example 1 |
|---|---|---|---|
| 0 | 1 | 1 | 1 |
| 18.5 | 0.51 | 0.59 | 0.43 |
| 43.5 | 0.34 | 0.45 | 0.29 |
| 78.5 | 0.22 | 0.36 | 0.14 |
| 267 | 0.12 | 0.18 | 0.03 |
| 1142 | 0.10 | 0.17 | 0.02 |

FIG. 4 is a view illustrating the changes in V_{oc}, J_{sc}, FF, and efficiency over time with respect to the organic solar cell prepared in Comparative Example 1 of the present specification. In this case, V_{oc}, J_{sc}, and FF mean an open-circuit voltage, a short-circuit current, and a fill factor, respectively.

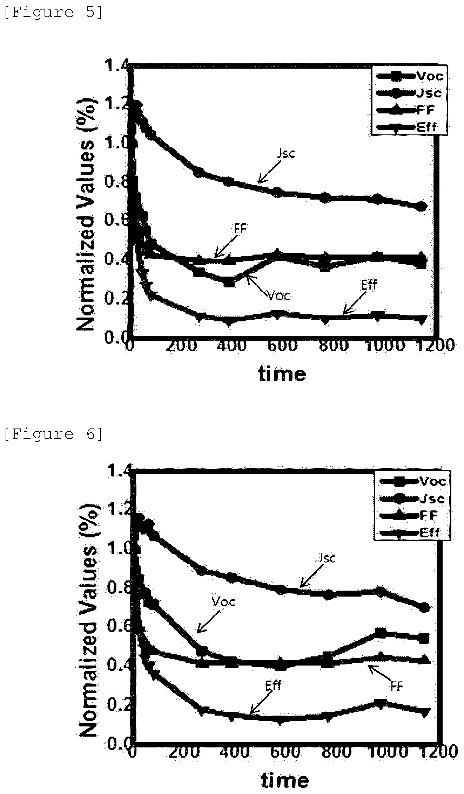

FIG. 5 is a view illustrating the changes in V_{oc}, J_{sc}, FF, and efficiency over time with respect to the organic solar cell prepared in Example 1 of the present specification.

FIG. 6 is a view illustrating the changes in V_{oc}, J_{sc}, FF, and efficiency over time with respect to the organic solar cell prepared in Example 2 of the present specification.

From the measurement results, it can be confirmed that when the single molecule and the polymer are simultaneously included as an electron donor, the efficiency and stability are excellent as compared to the case where only the single molecule or the polymer is included.

## Claims

1. A photoactive layer comprising:
an electron donor; and
an electron acceptor,
wherein the electron donor comprises: a single molecular material; and a polymer material,
a weight content of the electron donor is higher than a weight content of the electron acceptor, and
in the electron donor, a weight content of the single molecular material is higher than a weight content of the polymer material,
**characterized in that**
the polymer material is a copolymer comprising a unit represented by the following Formula 2: 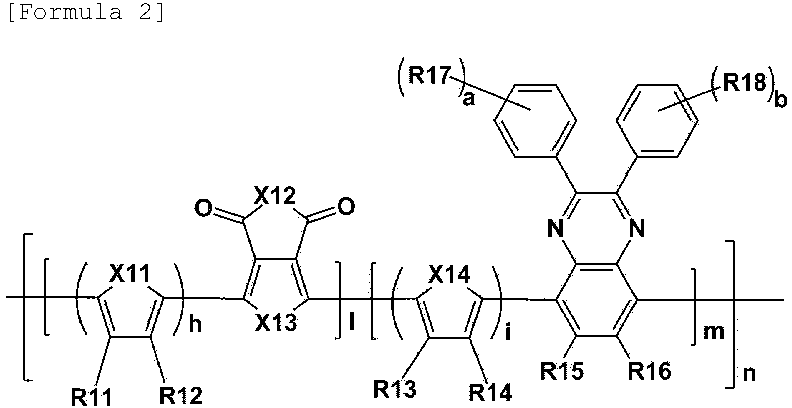 in Formula 2,
1 is a molar fraction, and a real number of 0 < 1 ≤ 1,
m is a molar fraction, and a real number of 0 < 1 ≤ 1,
1 + m = 1,
h and i are each an integer from 1 to 3,
when h and i are 2 or more, the structures in the parenthesis are the same as or different from each other,
n is an integer from 1 to 10,000,
a and b are each an integer from 1 to 5,
X11 to X14 are the same as or different from each other, and are each independently CRR', NR, O, SiRR', PR, S, GeRR', Se, and Te, and
R11 to R18, R, and R' are the same as or different from each other, and are each independently hydrogen; deuterium; a halogen group; a nitrile group; a nitro group; an imide group; an amide group; a hydroxyl group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted alkylamine group; a substituted or unsubstituted aralkylamine group; a substituted or unsubstituted arylamine group; a substituted or unsubstituted heteroarylamine group; a substituted or unsubstituted aryl group; a substituted or unsubstituted fluorenyl group; a substituted or unsubstituted carbazole group; and a substituted or unsubstituted heterocyclic group.

2. The photoactive layer of claim 1, wherein a weight ratio of the electron donor to the electron acceptor is 10 : 1 to 1.1 : 1.

3. The photoactive layer of claim 1, wherein a weight ratio of the single molecular material to the polymer material in the electron donor is 30 : 1 to 2 : 1.

4. The photoactive layer of claim 1, wherein the electron acceptor comprises a fullerene derivative.

5. The photoactive layer of claim 1, wherein the single molecular material is a compound represented by the following Formula 1: 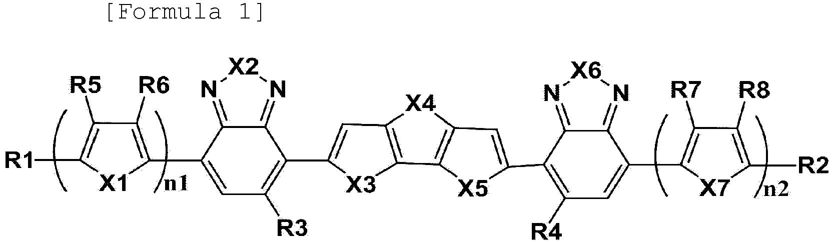 in Formula 1,
n1 and n2 are each an integer from 1 to 3, when n1 and n2 are 2 or more, the structures in the parenthesis are the same as or different from each other,
X1 to X7 are the same as or different from each other, and are each independently CRR', NR, O, SiRR', PR, S, GeRR', Se, and Te, and
R1 to R8, R, and R' are the same as or different from each other, and are each independently hydrogen; deuterium; a halogen group; a nitrile group; a nitro group; a hydroxyl group; a carbonyl group; an ester group; an imide group; an amide group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted amine group; a substituted or unsubstituted arylphosphine group; a substituted or unsubstituted phosphine oxide group; a substituted or unsubstituted aryl group; or a substituted or unsubstituted heterocyclic group.

6. An organic solar cell comprising:
a first electrode;
a second electrode provided to face the first electrode; and
an organic material layer having one or more layers provided between the first electrode and the second electrode and comprising the photoactive layer according to any one of claims 1 to 5.

7. The organic solar cell of claim 6, wherein the organic material layer further comprises a hole transport layer, a hole injection layer, or a layer which simultaneously transports and injects holes.

8. The organic solar cell of claim 6, wherein the organic material layer further comprises an electron injection layer, an electron transport layer, or a layer which simultaneously injects and transports electrons.

## Patentansprüche

1. Photoaktive Schicht, umfassend:
einen Elektronendonor; und
einen Elektronenakzeptor,
wobei der Elektronendonor ein Einzelmolekülmaterial und ein Polymermaterial umfasst,
der Gewichtsanteil des Elektronendonors größer als der Gewichtsanteil des Elektronenakzeptors ist, und
im Elektronendonor, der Gewichtsanteil des Einzelmolekülmaterials größer als der Gewichtsanteil des Polymermaterials ist,
**dadurch gekennzeichnet, dass**
das Polymermaterial ein Copolymer ist, das eine durch die folgende Formel 2 dargestellte Einheit umfasst: 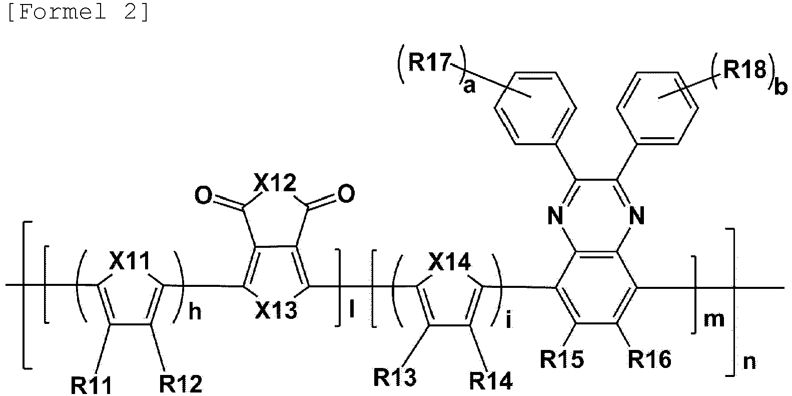
wobei in Formel 2,
1 einen Molanteil darstellt und eine reele Zahl von 0 < 1 ≤ 1 ist,
m einen Molanteil darstellt und eine reele Zahl von 0 < 1 ≤ 1 ist,
1 + m = 1,
h und i jeweils eine ganze Zahl von 1 bis 3 sind,
wobei wenn h und i 2 oder mehr sind, so sind die Strukturen in den Klammen gleich oder voneinander unterschiedlich,
n eine ganze Zahl 1 bis 10.000 ist,
a und b jeweils eine ganze Zahl von 1 bis 5 sind,
X11 bis X14 gleich oder voneinander unterschiedlich sind und jeweils unabhängig CRR', NR, O, SiRR', PR, S, GeRR', Se oder Te sind, und
R11 bis R18, R und R' gleich oder voneinander unterschiedlich sind und jeweils unabhängig Wasserstoff; Deuterium; eine Halogengruppe; eine Nitrilgruppe; eine Nitrogruppe; eine Imidgruppe; eine Amidgruppe; eine Hydroxylgruppe; eine substituierte oder unsubstituierte Alkylgruppe; eine substituierte oder unsubstituierte Cycloalkylgruppe; eine substituierte oder unsubstituierte Alkoxygruppe; eine substituierte oder unsubstituierte Aryloxygruppe; eine substituierte oder unsubstituierte Alkylthioxygruppe; eine substituierte oder unsubstituierte Arylthioxygruppe; eine substituierte oder unsubstituierte Alkylsulfoxygruppe; eine substituierte oder unsubstituierte Arylsulfoxygruppe; eine substituierte oder unsubstituierte Alkenylgruppe; eine substituierte oder unsubstituierte Silylgruppe; eine substituierte oder unsubstituierte Borgruppe; eine substituierte oder unsubstituierte Alkylamingruppe; eine substituierte oder unsubstituierte Aralkylamingruppe; eine substituierte oder unsubstituierte Arylamingruppe; eine substituierte oder unsubstituierte Heteroarylamingruppe; eine substituierte oder unsubstituierte Arylgruppe; eine substituierte oder unsubstituierte Fluorenylgruppe; eine substituierte oder unsubstituierte Carbazolgruppe; oder eine substituierte oder unsubstituierte heterocyclische Gruppe sind.

2. Photoaktive Schicht gemäß Anspruch 1, wobei das Gewichtsverhältnis des Elektronendonors zum Elektronenakzeptor 10 : 1 bis 1,1 : 1 beträgt.

3. Photoaktive Schicht gemäß Anspruch 1, wobei das Gewichtsverhältnis des Einzelmolekülmaterials zum Polymermaterial im Elektronendonor 0 : 1 bis 2 : 1 beträgt.

4. Photoaktive Schicht gemäß Anspruch 1, wobei der Elektronenakzeptor ein Fullerenderivat umfasst.

5. Photoaktive Schicht gemäß Anspruch 1, wobei das Einzelmolekülmaterial eine durch die folgende Formel 1 dargestellte Verbindung ist: 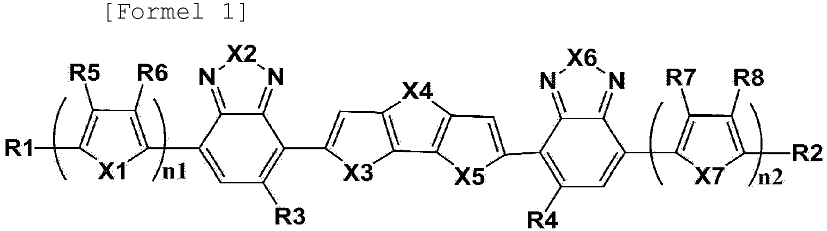
wobei in Formel 1,
n1 und n2 jeweils eine ganze Zahl von 1 bis 3 sind,
wobei wenn n1 und n2 2 oder mehr sind, so sind die Strukturen in den Klammern gleich oder voneinander unterschiedlich,
X1 bis X7 gleich oder voneinander unterschiedlich sind und jeweils unabhängig CRR', NR, O, SiRR', PR, S, GeRR', Se oder Te sind, and
R1 bis R8, R und R' gleich oder voneinander unterschiedlich sind und jeweils unabhängig Wasserstoff; Deuterium; eine Halogengruppe; eine Nitrilgruppe; eine Nitrogruppe; eine Hydroxylgruppe; eine Carbonylgruppe; eine Estergruppe; eine Imidgruppe; eine Amidgruppe; eine substituierte oder unsubstituierte Alkylgruppe; eine substituierte oder unsubstituierte Cycloalkylgruppe; eine substituierte oder unsubstituierte Alkoxygruppe; eine substituierte oder unsubstituierte Aryloxygruppe; eine substituierte oder unsubstituierte Alkylthioxygruppe; eine substituierte oder unsubstituierte Arylthioxygruppe; eine substituierte oder unsubstituierte Alkylsulfoxygruppe; eine substituierte oder unsubstituierte Arylsulfoxygruppe; eine substituierte oder unsubstituierte Alkenylgruppe; eine substituierte oder unsubstituierte Silylgruppe; eine substituierte oder unsubstituierte Borgruppe; eine substituierte oder unsubstituierte Amingruppe; eine substituierte oder unsubstituierte Arylphosphangruppe; eine substituierte oder unsubstituierte Phosphanoxidgruppe; eine substituierte oder unsubstituierte Arylgruppe; oder eine substituierte oder unsubstituierte heterocyclische Gruppe sind.

6. Organische Solarzelle, umfassend:
eine erste Elektrode;
eine der ersten Elektrode gegenüberstehend angeordnete zweite Elektrode; und
eine Schicht organischen Materials, die eine oder mehrere zwischen der ersten und der zweiten Elektrode angeordnete Schichten aufweist und die photoaktive Schicht gemäß einem der Ansprüche 1 bis 5 umfasst.

7. Organische Solarzelle gemäß Anspruch 6, wobei die Schicht organischen Materials weiterhin eine Lochtransportschicht, eine Lochinjektionsschicht oder eine Schicht, die Löcher transprortiert und injiziert, umfasst.

8. Organische Solarzelle gemäß Anspruch 6, wobei die Schicht organischen Materials weiterhin eine Elektroneninjektionsschicht, eine Elektronentransportschicht, oder eine Schicht, die Elektronen injiziert und transprortiert, umfasst.

## Revendications

1. Couche photoactive comprenant :
un donneur d'électrons ; et
un accepteur d'électrons,
dans laquelle le donneur d'électrons comprend : un matériau monomoléculaire ; et un matériau polymère,
une teneur en poids du donneur d'électrons est supérieure à une teneur en poids de l'accepteur d'électrons, et
dans le donneur d'électrons, une teneur en poids du matériau monomoléculaire est supérieure à une teneur en poids du matériau polymère,
**caractérisée en ce que**
le matériau polymère est un copolymère comprenant une unité représentée par la Formule 2 suivante : 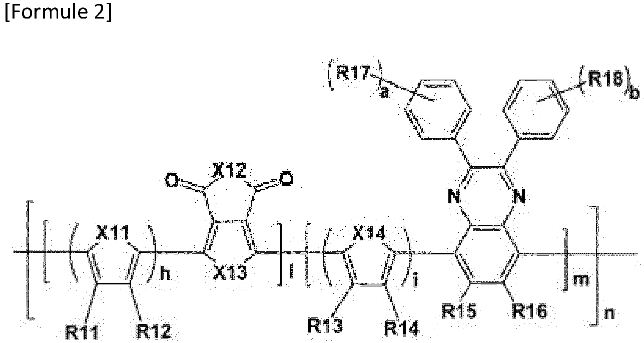
dans la Formule 2,
1 est une fraction molaire, et un nombre réel de 0 < 1 ≤ 1,
m est une fraction molaire, et un nombre réel de 0 < 1 ≤ 1,
1 + m = 1,
h et i sont chacun un nombre entier allant de 1 à 3,
lorsque h et i sont 2 ou plus, les structures dans la parenthèse sont identiques ou différentes l'une de l'autre,
n est un nombre entier allant de 1 à 10 000,
a et b sont chacun un nombre entier allant de 1 à 5,
X11 à X14 sont identiques ou différents les uns des autres, et sont chacun indépendamment CRR', NR, O, SiRR', PR, S, GeRR', Se, et Te, et
R11 à R18, R, et R' sont identiques ou différents les uns des autres, et sont chacun indépendamment de l'hydrogène; du deutérium ; un groupe halogène; un groupe nitrile ; un groupe nitro ; un groupe imide ; un groupe amide ; un groupe hydroxyle ; un groupe alkyle substitué ou non substitué ; un groupe cycloalkyle substitué ou non substitué ; un groupe alcoxy substitué ou non substitué ; un groupe aryloxy substitué ou non substitué ; un groupe alkylthioxy substitué ou non substitué ; un groupe arylthioxy substitué ou non substitué ; un groupe alkylsulfoxy substitué ou non substitué ; un groupe arylsulfoxy substitué ou non substitué ; un groupe alcényle substitué ou non substitué ; un groupe silyle substitué ou non substitué ; un groupe bore substitué ou non substitué ; un groupe alkylamine substitué ou non substitué ; un groupe aralkylamine substitué ou non substitué; un groupe arylamine substitué ou non substitué; un groupe hétéroarylamine substitué ou non substitué ; un groupe aryle substitué ou non substitué ; un groupe fluorényle substitué ou non substitué ; un groupe carbazole substitué ou non substitué ; et un groupe hétérocyclique substitué ou non substitué.

2. Couche photoactive selon la revendication 1, dans laquelle un rapport en poids du donneur d'électrons sur l'accepteur d'électrons est 10:1 à 1,1 : 1.

3. Couche photoactive selon la revendication 1, dans laquelle un rapport en poids du matériau monomoléculaire sur le matériau polymère dans le donneur d'électrons est 30: 1à 2 : 1.

4. Couche photoactive selon la revendication 1, dans laquelle l'accepteur d'électrons comprend un dérivé fullerène.

5. Couche photoactive selon la revendication 1, dans laquelle le matériau monomoléculaire est un composé représenté par la Formule 1 suivante : 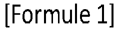 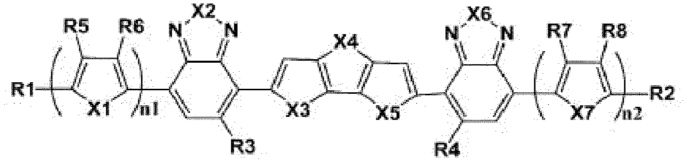
dans la Formule 1,
n1 et n2 sont chacun un nombre entier allant de 1 à 3, lorsque n1 et n2 sont 2 ou plus, les structures dans la parenthèse sont identiques ou différentes les unes des autres,
X1 à X7 sont identiques ou différents les uns des autres, et sont chacun indépendamment CRR', NR, O, SiRR', PR, S, GeRR', Se, et Te, et
R1 à R8, R, et R' sont identiques ou différents les uns des autres, et sont chacun indépendamment de l'hydrogène; du deutérium ; un groupe halogène; un groupe nitrile ; un groupe nitro ; un groupe hydroxyle ; un groupe carbonyle ; un groupe ester ; un groupe imide ; un groupe amide; un groupe alkyle substitué ou non substitué; un groupe cycloalkyle substitué ou non substitué ; un groupe alcoxy substitué ou non substitué ; un groupe aryloxy substitué ou non substitué ; un groupe alkylthioxy substitué ou non substitué ; un groupe arylthioxy substitué ou non substitué ; un groupe alkylsulfoxy substitué ou non substitué ; un groupe arylsulfoxy substitué ou non substitué ; un groupe alcényle substitué ou non substitué ; un groupe silyle substitué ou non substitué ; un groupe bore substitué ou non substitué ; un groupe amine substitué ou non substitué ; un groupe arylphosphine substitué ou non substitué ; un groupe oxyde de phosphine substitué ou non substitué ; un groupe aryle substitué ou non substitué ; ou un groupe hétérocyclique substitué ou non substitué.

6. Cellule solaire organique comprenant :
une première électrode ;
une seconde électrode disposée pour faire face à la première électrode ; et
une couche de matériau organique présentant une ou plusieurs couches disposées entre la première électrode et la seconde électrode et comprenant la couche photoactive selon l'une quelconque des revendications 1 à 5.

7. Cellule solaire organique selon la revendication 6, dans laquelle la couche de matériau organique comprend en outre une couche de transport de trous, une couche d'injection de trous, ou une couche qui transporte et injecte simultanément des trous.

8. Cellule solaire organique selon la revendication 6, dans laquelle la couche de matériau organique comprend en outre une couche d'injection d'électrons, une couche de transport d'électrons, ou une couche qui injecte et transporte simultanément des électrons.
